# FASCICULE DE BREVET EUROPEEN

(11) **EP 3 800 775 B1**
(45) Date de publication et mention de la délivrance du brevet: **15.07.2026**
(21) Numéro de dépôt: 20197960.6
(22) Date de dépôt: 24.09.2020
(51) Int. Cl.: H02M 7/217, H02M 1/36, G05F 1/56, G05F 3/18, G05F 1/46, H02M 7/06

(54) **CIRCUIT DE REGULATION EN TENSION ET MODULE D'ALIMENTATION REGULEE**
SPANNUNGSREGULIERUNGSSCHALTKREIS UND REGULIERTES STROMVERSORGUNGSMODUL
CIRCUIT FOR CONTROLLING VOLTAGE AND CONTROLLED SUPPLY MODULE

(30) Priorité: 01.10.2019 FR 1910872
(43) Date de publication de la demande: 07.04.2021
(73) Titulaire: Schneider Electric Industries SAS, 92500 Rueil Malmaison (FR)
(72) Inventeur: BRENGUIER, Jérôme, 38240 Meylan (GA)
(74) Mandataire: Lavoix

(56) Documents cités:
- EP-A1- 2 115 862
- EP-A1- 3 139 484
- EP-A2- 0 651 499
- EP-A2- 0 763 878
- FR-A1- 2 719 725
- JP-A- 2005 216 194
- JP-A- 2011 034 411
- US-A- 4 754 388
- US-A- 5 652 825
- US-A- 6 094 040
- US-A1- 2014 126 258

## Description

### Domaine technique

La présente invention concerne un circuit de régulation en tension et un module d'alimentation régulée comportant un tel circuit de régulation.

### Etat de la technique

De nombreux équipements alimentés par une source d'énergie telle qu'un réseau de distribution d'énergie électrique, comportent un module d'alimentation régulée permettant de transformer une tension d'entrée alternative ou continue du réseau de distribution en une très basse tension continue de sortie, utilisable pour l'alimentation de circuits électroniques ou électromécaniques. La puissance à transmettre entre l'entrée et la sortie ainsi que l'écart entre la tension d'entrée et la tension de sortie sont des facteurs prépondérants dans le choix de conception de tels modules d'alimentation. Les alimentations utilisant un transformateur de tension sont largement utilisées pour leur faible coût mais nécessitent une tension d'entrée sinusoïdale et le transformateur est un composant pouvant être encombrant ou difficile à implanter dans un module d'alimentation. Les alimentations à découpage sont connues pour transmettre des puissances importantes avec un rendement excellent tout en étant très compactes. Pour cela, ce type d'alimentation est largement employé dans les équipements électroniques dès que la consommation dépasse quelques Watts. En revanche, quand l'équipement consomme très peu d'énergie, typiquement quelques centaines de milliwatts au maximum, tout en étant connecté à un réseau de distribution fournissant une tension d'entrée élevée, par exemple 240 Volt, l'utilisation d'une alimentation à découpage représente souvent un cout disproportionné par rapport au cout des circuits alimentés.

Une technologie d'alimentation linéaire est bien adaptée pour fournir une très basse tension continue et une faible puissance à un équipement mais se pose alors le problème de la puissance que doit dissiper une telle alimentation linéaire, ladite puissance étant proportionnelle à l'écart de tension entre la tension d'entrée et la tension de sortie et au courant d'alimentation fourni. La demande de brevet DE 3304759 A1 décrit un dispositif d'alimentation linéaire utilisant un commutateur à l'état passant uniquement quand la tension d'entrée est faible de manière à limiter la dissipation d'énergie dans le commutateur. Un condensateur accumule l'énergie utilisée quand le commutateur est ouvert. Selon un principe similaire, la demande de brevet EP 0 600 384 A2 décrit un dispositif d'alimentation linéaire utilisant également un commutateur, celui-ci étant commandé par un circuit alimenté soit par le réseau de distribution électrique quand la tension d'entrée est suffisante, soit par un condensateur chargé à la tension de sortie quand le commutateur est ouvert. Ainsi, le circuit de commande du commutateur est alimenté quelle que soit l'état du commutateur ce qui évite toute commande intempestive dudit commutateur. La demande de brevet FR 2 621 751 A1 invalide toute mise en conduction du commutateur quand la tension de sortie est à un niveau suffisant.

De l'art antérieur est également connu des documents JP 2011-034411 A, FR 2719725 A1 et US 2014/126258 A1.

Les documents de l'art antérieur décrivent des circuits d'alimentation linéaire de faible puissance, agencés pour dissiper peu d'énergie. Ils présentent cependant la particularité de ne commencer à fonctionner qu'autour du passage à zéro de la tension d'entrée. Cette particularité n'est pas gênante quand la durée de démarrage de l'équipement n'est pas critique, par exemple dans le cas d'un rasoir électrique tel que décrit dans le document DE 3304759 A1 cité précédemment ou dans le cas de petits équipements électroménagers. En revanche, les circuits décrits dans l'art antérieur ne permettent pas une alimentation fournissant une tension de sortie très rapidement après la mise sous tension, typiquement en quelques millisecondes, pour alimenter un ou plusieurs circuits destinés, par exemple, à assurer une fonction de sécurité.

### Exposé de l'invention

Pour répondre à un tel problème de réduction de puissance interne dissipée associé à une contrainte de fourniture très rapide d'une très basse tension de sortie après une mise sous tension, la présente invention a pour objet un circuit de régulation en tension conforme à la revendication 1. Ce circuit de régulation comporte au moins une borne d'entrée, une borne de référence et une borne de sortie, une source de tension, connectée entre la borne d'entrée et la borne de référence, fournissant une tension d'entrée, ledit circuit de régulation fournissant une tension de sortie régulée entre la borne de sortie et la borne de référence, et comportant :
- un régulateur de tension,
- un interrupteur connecté en série avec le régulateur de tension entre la borne d'entrée et la borne de sortie, ledit interrupteur et ledit régulateur de tension formant un premier ensemble,
- un premier circuit de comparaison, connecté à la borne d'entrée et à la borne de sortie, ledit premier circuit de comparaison étant agencé pour comparer l'écart d'amplitude entre la tension d'entrée et la tension de sortie par rapport à un premier seuil,
- un second circuit de comparaison, connecté à la borne de sortie 12 et à la borne de référence 11, ledit second circuit de comparaison 24 étant agencé pour comparer l'amplitude de la tension de sortie par rapport à un second seuil, et
- un circuit de commande, connecté au premier circuit de comparaison, au second circuit de comparaison et à l'interrupteur, ledit circuit de commande étant agencé pour commander une fermeture ou une ouverture de l'interrupteur,

ledit circuit de régulation étant tel que le circuit de commande commande une ouverture ou une fermeture de l'interrupteur en fonction :
   - de la comparaison de l'écart d'amplitude entre la tension d'entrée et la tension de sortie par rapport au premier seuil, et en fonction
   - de la comparaison de l'amplitude de la tension de sortie par rapport au second seuil,
le circuit de commande commande :
   - une ouverture de l'interrupteur quand l'écart d'amplitude entre la tension d'entrée et la tension de sortie est supérieur ou égal au premier seuil,
   - une fermeture de l'interrupteur quand l'écart d'amplitude entre la tension d'entrée et la tension de sortie est inférieur au premier seuil, et
   - une fermeture de l'interrupteur quand l'écart d'amplitude entre la tension d'entrée et la tension de sortie est supérieur ou égal au premier seuil et que la tension de sortie est inférieure au second seuil.

Préférentiellement, le premier ensemble constitué par l'interrupteur connecté en série avec le régulateur de tension est formé par :
- un premier transistor dont le collecteur est connecté à la borne d'entrée et dont l'émetteur est connecté à la borne de sortie,
- une première résistance, une première extrémité de ladite première résistance étant connectée à la base du premier transistor, une deuxième extrémité de la première résistance étant connectée au collecteur du premier transistor, et
- une première référence de tension dont l'anode est connectée à la borne de référence et la cathode est connectée à la base du premier transistor.

Avantageusement, l'amplitude de la tension de sortie est fixée par la tension de référence fournie par la première référence de tension.

Préférentiellement, le premier circuit de comparaison est formé d'un deuxième transistor de type bipolaire NPN dont le collecteur est connecté à la base du premier transistor et dont la base est connectée à une première extrémité d'un deuxième ensemble formé par une deuxième résistance connectée en série avec une deuxième référence de tension, une deuxième extrémité du deuxième ensemble étant connectée à la borne d'entrée, l'anode de la deuxième référence de tension étant orientée vers la base du premier transistor.

Avantageusement, l'amplitude du premier seuil est fixée par la tension de référence fournie par la deuxième référence de tension.

Préférentiellement, le second circuit de comparaison est formé d'un troisième transistor de type bipolaire PNP dont l'émetteur est connecté à l'émetteur du deuxième transistor, le collecteur dudit troisième transistor étant connecté à la borne de sortie, la base étant connectée à une première extrémité d'un troisième ensemble formé par une troisième résistance connectée en série avec une troisième référence de tension, une deuxième extrémité du troisième ensemble étant connectée à la borne de référence, l'anode de ladite troisième référence de tension étant orientée vers la borne de référence.

Avantageusement, l'amplitude du second seuil est fixée par la tension de référence fournie par la troisième référence de tension.

Préférentiellement, une quatrième résistance est connectée en parallèle entre la base et l'émetteur du deuxième transistor et une cinquième résistance est connectée en parallèle entre la base et l'émetteur du troisième transistor.

De préférence, un condensateur est connecté entre la borne de sortie et la borne de référence

L'invention porte également sur un module d'alimentation régulée comportant :
- un circuit de régulation tel que décrit précédemment,
- au moins deux bornes de connexion réseau connectées à un réseau de distribution d'énergie électrique fournissant une tension alternative,
- un pont redresseur comportant des entrées alternatives, une sortie positive et une sortie négative, les entrées alternatives étant connectées aux bornes de connexion réseau, la sortie positive étant connectée à la borne d'entrée du circuit de régulation, la sortie négative étant connectée à la borne de référence du circuit de régulation.

Avantageusement, le module d'alimentation régulée comporte un convertisseur à découpage de type Buck, une entrée dudit convertisseur à découpage étant connectée à la borne de sortie du circuit de régulation et une sortie du convertisseur à découpage fournissant une tension d'alimentation régulée.

### Brève description des dessins

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
[Fig. 1] la figure 1 représente, sous forme d'un schéma bloc, un circuit de régulation en tension,
[Fig. 2] la figure 2 représente un premier mode de réalisation du circuit de régulation,
[Fig. 3] la figure 3 représente un schéma de réalisation du circuit de régulation selon un mode préférentiel,
[Fig. 4] la figure 4 représente un schéma de réalisation d'un module d'alimentation régulée, et
[Fig. 5] les figures 5a et 5b sont des représentations temporelles des variations d'une tension d'entrée du module d'alimentation et d'une tension de sortie régulée fournie par le module d'alimentation.

### Description détaillée de modes de réalisation préférés

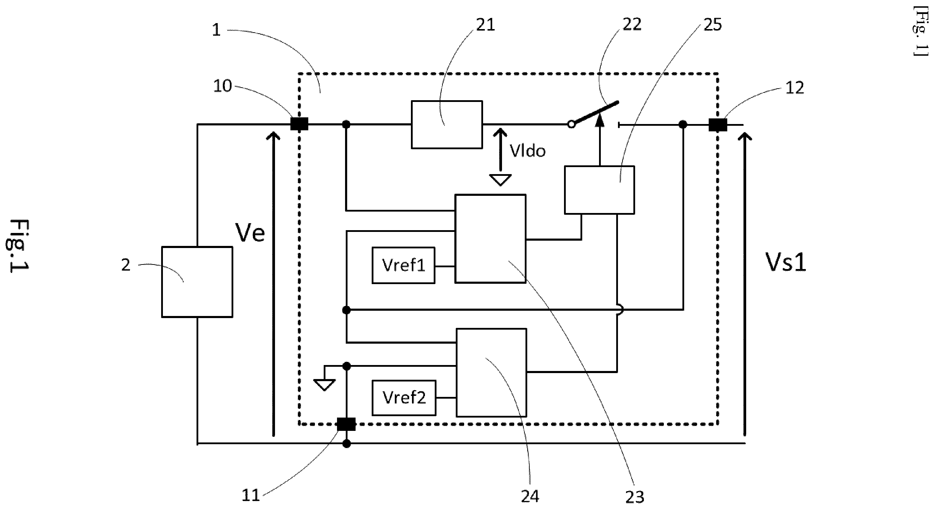

La figure 1 représente, sous forme d'un schéma bloc, un circuit de régulation en tension 1 comportant au moins une borne d'entrée 10, une borne de référence 11 et une borne de sortie 12. Une source de tension 2 est connectée entre la borne d'entrée 10 et la borne de référence 11 et fournit une tension d'entrée Ve. Ledit circuit de régulation 1 est agencé pour fournir une tension de sortie régulée Vs1 entre la borne de sortie 12 et la borne de référence 11. Pour cela, le circuit de régulation 1 comporte :
- un régulateur de tension 21,
- un interrupteur 22, connecté en série avec le régulateur de tension 21 entre la borne d'entrée 10 et la borne de sortie 12, ledit interrupteur 22 et ledit régulateur de tension 21 formant un premier ensemble,
- un premier circuit de comparaison 23, connecté à la borne d'entrée 10 et à la borne de sortie 12, ledit premier circuit de comparaison 23 étant agencé pour comparer l'amplitude de l'écart entre la tension d'entrée Ve et la tension de sortie Vs1 par rapport à un premier seuil Vref1,
- un second circuit de comparaison 24, connecté à la borne de sortie 12 et à la borne de référence 11, ledit second circuit de comparaison 24 étant agencé pour comparer l'amplitude de la tension de sortie Vs1 par rapport à un second seuil Vref2, et
- un circuit de commande 25, connecté au premier circuit de comparaison 23, au second circuit de comparaison 24 et à l'interrupteur 22, ledit circuit de commande 25 étant agencé pour commander une fermeture ou une ouverture de l'interrupteur 22 en fonction de la comparaison de l'écart d'amplitude entre la tension d'entrée Ve et la tension de sortie Vs1 par rapport au premier seuil Vref1, et en fonction de la comparaison de l'amplitude de la tension de sortie Vs1 par rapport au second seuil Vref2. Cet effet technique permet une fourniture de la tension de sortie Vs1 de manière indépendante de l'angle de phase de la tension d'entrée Ve au moment de la connexion du circuit de commande à la source de tension 2 contrairement aux dispositifs décrits dans l'art antérieur qui doivent attendre un passage de la tension d'entrée proche du zéro avant de délivrer une tension de sortie Vs1.

le circuit de commande 25 commande :
- une ouverture de l'interrupteur 22 quand l'écart d'amplitude entre la tension d'entrée Ve et la tension de sortie Vs1 est supérieur ou égal au premier seuil Vref1,
- une fermeture de l'interrupteur 22 quand l'écart d'amplitude entre la tension d'entrée Ve et la tension de sortie Vs1 est inférieur au premier seuil Vref1, et
- une fermeture de l'interrupteur 22 quand l'écart d'amplitude entre la tension d'entrée Ve et la tension de sortie Vs1 est supérieur ou égal au premier seuil Vref1 et que la tension de sortie Vs1 est inférieure au second seuil Vref2.

La tension d'entrée Ve fournie par la source de tension 2 peut être une tension alternative redressée mono ou double alternance, une tension continue sur laquelle sont superposées une ou plusieurs tensions alternatives ou encore une tension continue variant lentement. L'amplitude de la tension d'entrée Ve varie, par exemple, entre 0 Volt et 400 Volt.

La sortie du régulateur de tension 21, connectée à l'interrupteur 22, fournit une tension régulée Vldo, référencée par rapport au potentiel de la borne de référence 11. La tension régulée Vldo est préférentiellement comprise entre 10 et 50 Volt.

La tension de sortie Vs1 régulée est une tension continue lisse ou comportant une ondulation.

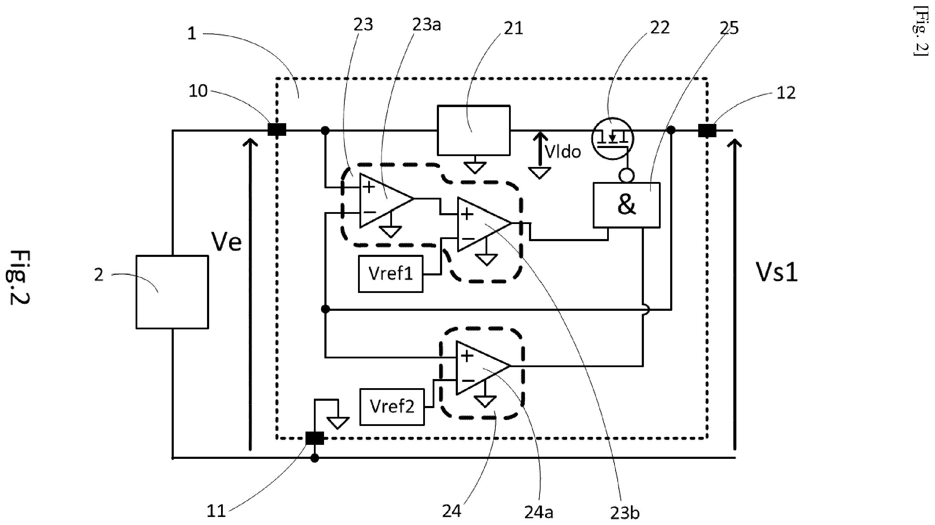

La figure 2 représente un premier mode de réalisation du circuit de régulation 1 en lien avec le schéma bloc représenté en figure 1. Le régulateur de tension 21 est préférentiellement un circuit conventionnel de régulation linéaire de tension appelé également « LDO » pour « Low Dropout Regulator », ayant pour avantage une faible chute de tension entre son entrée et sa sortie, tel qu'un circuit de la famille 78 du fabriquant STMicroelectronics ou un circuit de type LM338 du fabriquant Texas Instrument. L'entrée du régulateur de tension est connectée à la borne d'entrée 10. L'interrupteur 22 est formé par au moins un transistor bipolaire ou un transistor à effet de champ de type MOSFET « Metal Oxide Semiconductor Field Effect Transistor » ou encore un transistor JFET en carbure de silicium « SiC » ou tout autre composant permettant une commutation rapide de courant électrique et dont la résistance série à l'état passant est faible. Un tel transistor est connecté en série entre la sortie du régulateur de tension 21 et la borne de sortie 12.

Le premier circuit de comparaison 23 comporte un amplificateur différentiel 23a dont une entrée positive est connectée à la borne d'entrée 10 et une entrée négative est connectée à la borne de sortie 12. La sortie de l'amplificateur différentiel 23a est connectée à une entrée positive d'un premier comparateur de tension 23b pour fournir une tension dont l'amplitude est égale à l'écart d'amplitude entre la tension d'entrée Ve et la tension de sortie Vs1. L'entrée positive du premier comparateur 23b est donc portée à un potentiel égal à (Ve - Vs1). Une entrée négative du premier comparateur 23b est connectée à une première référence de tension Vref1. Une sortie du premier comparateur 23b fournit un résultat de comparaison de l'écart d'amplitude entre la tension d'entrée Ve et la tension de sortie Vs1 par rapport à un premier seuil Vref1. Le premier comparateur 23b compare donc le potentiel (Ve - Vs1) par rapport au potentiel Vref1. Quand le potentiel (Ve - Vs1) est supérieur au potentiel Vref1, la sortie du premier comparateur 23b passe à un état haut, sinon la sortie du premier comparateur 23b est dans un état bas.

Le second circuit de comparaison 24 comporte un second comparateur de tension 24a pour comparer l'amplitude de la tension de sortie Vs1 par rapport à un second seuil de tension Vref2. Pour cela, la borne de sortie 12 est connectée à une entrée positive du second comparateur 24a pour fournir une tension dont l'amplitude est égale à la tension de sortie Vs1. Une entrée négative du second comparateur 24a est connectée à une seconde référence de tension Vref2. Quand la tension de sortie Vs1 est supérieure au potentiel du second seuil Vref2, la sortie du second comparateur 24a passe à un état haut, sinon la sortie du second comparateur 24a est dans un état bas.

Une première entrée du circuit de commande 25 est connectée à la sortie du premier comparateur 23b, une seconde entrée du circuit de commande 25 est connectée à la sortie du second comparateur 24a. Le premier circuit de commande 25 est préférentiellement une porte logique de type NON-ET (ou « NAND gate» en anglais) dont la sortie est dans un état bas quand ses deux entrées sont dans un état haut. Ladite sortie du premier circuit de commande 25 est connectée à une électrode de commande de l'interrupteur 22, par exemple une base d'un transistor bipolaire ou une grille de transistor FET. Un état haut en sortie du premier circuit de commande 25 commande un état passant du transistor et donc une fermeture de l'interrupteur 22. Un tel état haut en sortie du premier circuit de commande 25 est obtenu quand l'une de ses entrées est dans un état bas soit encore quand la différence de potentiel (Ve - Vs1) est inférieure au potentiel Vref1 ou quand la tension de sortie Vs1 est inférieure au potentiel du second seuil Vref2. En revanche, quand les deux entrées du circuit de commande 25 sont dans un état haut, c'est-à-dire que la différence de potentiel (Ve - Vs1) est supérieure au potentiel Vref1 et que la tension de sortie Vs1 est supérieure au potentiel du second seuil Vref2, alors la sortie du premier circuit de commande 25 passe dans un état bas et commande ainsi une ouverture de l'interrupteur 22.

La logique de commande ainsi décrite et exécutée par le circuit de commande 25 permet de commander :
- une fermeture de l'interrupteur 22 quand l'écart d'amplitude entre la tension d'entrée Ve et la tension de sortie Vs1 est inférieur au premier seuil Vref1, ce qui permet un fonctionnement du régulateur de tension 21 pour fournir une tension de sortie Vs1 régulée,
- une ouverture de l'interrupteur 22 quand la tension l'écart d'amplitude entre la tension d'entrée Ve et la tension de sortie Vs1 est supérieur ou égal au premier seuil Vref1, ce qui évite toute dissipation d'énergie dans le régulateur de tension 21, et
- une fermeture de l'interrupteur 22 quand l'écart d'amplitude entre la tension d'entrée Ve et la tension de sortie Vs1 est supérieur ou égal au premier seuil Vref1 et que la tension de sortie Vs1 est inférieure au second seuil Vref2, ce qui permet la fourniture de la tension de sortie Vs1 dès l'apparition d'une tension d'entrée Ve, cette dernière configuration étant particulièrement importante au moment d'une mise sous tension du circuit de régulation afin de permettre une alimentation d'un récepteur connecté entre la borne de sortie 12 et la borne de référence 11. Cette période temporelle ne dure que quelques millisecondes et l'énergie dissipée dans le régulateur de tension 21 reste faible.

La logique de commande de l'interrupteur 22 décrite précédemment privilégie une fermeture de l'interrupteur 22 sauf dans le cas où la différence de potentiel (Ve - Vs1) est supérieure au potentiel Vref1 et que la tension de sortie Vs1 est supérieure au potentiel du second seuil Vref2. Selon ladite logique, la fermeture de l'interrupteur 22 quand la tension d'entrée Ve est supérieure ou égale au premier seuil Vref1 et que la tension de sortie Vs1 est inférieure au second seuil Vref2 est prioritaire par rapport à l'ouverture de l'interrupteur 22 quand la tension d'entrée Ve est supérieure ou égale au premier seuil Vref1.

En variante, la logique de commande de l'interrupteur 22 peut aisément être modifiée pour exécuter une ouverture de l'interrupteur 22 dans le cas où la différence de potentiel (Ve - Vs1) est inférieure au potentiel Vref1 et que la tension de sortie Vs1 est supérieure au potentiel du second seuil Vref2, par exemple dans le cas où aucune énergie n'est consommée entre la borne de sortie 12 et la borne de référence 11.

Selon une autre variante, la gestion de l'interrupteur 22 peut être assurée uniquement en fonction de l'amplitude de la tension d'entrée Ve et de la tension de sortie Vs1. Pour cela, l'amplificateur différentiel 23a n'est pas nécessaire, l'entrée positive du premier comparateur de tension 23b est connectée à la borne d'entrée 10. La sortie du premier comparateur 23b fournit ainsi un résultat de comparaison entre la tension d'entrée Ve par rapport au premier seuil Vref1, le premier seuil Vref1 étant ajusté en conséquence. Le circuit de commande 25 exécute la logique de commande décrite précédemment.

Selon une autre variante, les premier et second circuits de comparaison 23, 24 et le circuit de commande 25 peuvent être réalisés au moyen d'un ou plusieurs micro-automate ou microprocesseur ou tout dispositif comportant des circuits de conversion analogique-numérique et des circuits adaptés pour réaliser du traitement d'information.

Selon encore une autre variante, le régulateur de tension 21 et l'interrupteur 22 sont intégrés dans un même composant tel qu'un régulateur linéaire de tension possédant une entrée de commande ON/OFF, par exemple un circuit portant la référence « LM9070 Low-Dropout System Voltage Regulator with Keep-Alive ON/OFF Control » du fabriquant Texas Instrument.

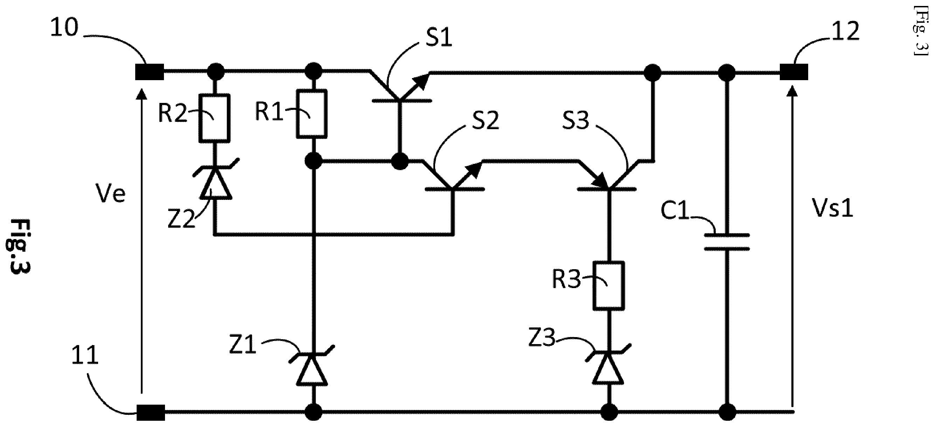

La figure 3 est un schéma de réalisation d'un mode préférentiel du circuit de régulation décrit précédemment. Ce mode de réalisation met en œuvre très peu de composants, il est donc extrêmement économique.

Le premier ensemble constitué par l'interrupteur 22 connecté en série avec le régulateur de tension 21 est formé par :
- un premier transistor S1, préférentiellement de type bipolaire NPN, dont le collecteur est connecté à la borne d'entrée 10, l'émetteur est connecté à la borne de sortie 12,
- une première résistance R1, une première extrémité de ladite première résistance R1 étant connectée à la base du premier transistor S1, une deuxième extrémité de la première résistance R1 étant connectée au collecteur du premier transistor S1, et
- une première référence de tension Z1 dont l'anode est connectée à la borne de référence 11 et la cathode est connectée à la base du premier transistor S1.

Dans le cas où le premier transistor S1 est de type JFET, MOSFET, IGBT ou SiC canal N, il convient de connecter le drain du transistor en lieu et place du collecteur, la grille en lieu et place de la base et la source en lieu et place de l'émetteur.

L'amplitude de la tension de sortie Vs1 est fixée par la tension de référence fournie par la première référence de tension Z1. En effet, la tension de sortie Vs1 est égale à la tension de référence fournie par la première référence de tension Z1 à laquelle il convient de retrancher la tension base-émetteur du premier transistor S1, par exemple sensiblement égale à 0,6 Volt pour un premier transistor S1 de type bipolaire. Préférentiellement, la première référence de tension Z1 est une diode zener. Préférentiellement, la tension de référence fournie par ladite première référence de tension Z1 est comprise entre 10 Volt et 90 Volt.

Le premier circuit de comparaison 23 est formé d'un deuxième transistor S2 préférentiellement de type bipolaire NPN dont le collecteur est connecté à la base du premier transistor S1 et dont la base est connectée à une première extrémité d'un deuxième ensemble formé par une deuxième résistance R2 connectée en série avec une deuxième référence de tension Z2, une deuxième extrémité du deuxième ensemble étant connectée à la borne d'entrée 10. L'anode de la deuxième référence de tension Z2 est orientée vers la base du deuxième transistor S2.

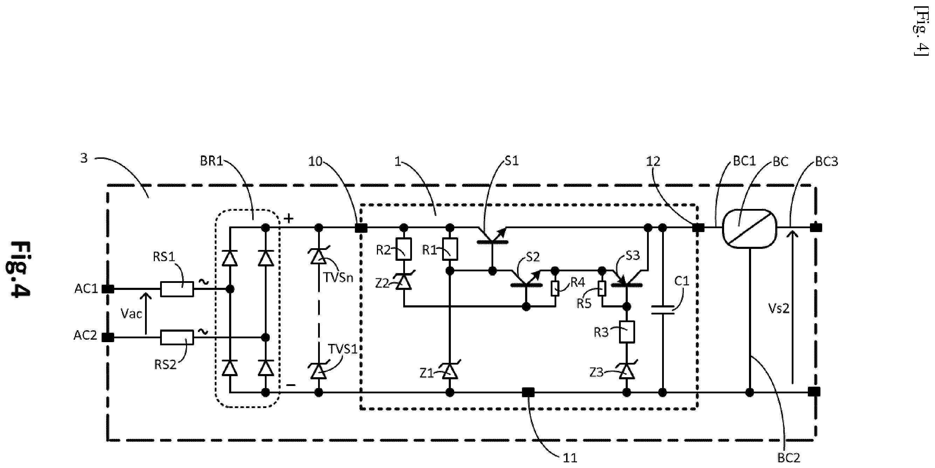

L'amplitude du premier seuil Vref1 est fixée par la tension de référence fournie par la deuxième référence de tension Z2 ainsi qu'il sera expliqué ultérieurement. Préférentiellement, la deuxième référence de tension Z2 est une diode zener. De préférence, la tension de référence fournie par ladite deuxième référence de tension Z2 est comprise entre 50 Volt et 90 Volt. Les positions de la deuxième résistance R2 et de la deuxième référence de tension Z2 peuvent être inversées, tout en restant en série et dans la mesure où l'anode de la deuxième référence de tension Z2 est orientée vers la base du deuxième transistor S2. Les figures 3 et 4 représentent l'anode de la deuxième référence de tension Z2 connectée à la base du deuxième transistor S2 et une première extrémité de la deuxième résistance R2 connectée à la borne d'entrée 10. Il est également possible de connecter la cathode de la deuxième référence de tension Z2 à la borne d'entrée 10 et connecter la première extrémité de la deuxième résistance R2 à l'anode de la deuxième référence de tension Z2.

Le second circuit de comparaison 24 est formé d'un troisième transistor S3 préférentiellement de type bipolaire PNP dont l'émetteur est connecté à l'émetteur du deuxième transistor S2, le collecteur dudit troisième transistor S3 étant connecté à la borne de sortie 12 et la base étant connectée à une première extrémité d'un troisième ensemble formé par une troisième résistance R3 connectée en série avec une troisième référence de tension Z3, une deuxième extrémité dudit troisième ensemble étant connectée à la borne de référence 11, l'anode de ladite troisième référence de tension Z3 étant orientée vers la borne de référence 11. L'amplitude du second seuil Vref2 est fixée par la tension de référence fournie par la troisième référence de tension Z3. Préférentiellement, la troisième référence de tension Z3 est une diode zener. De préférence, la tension de référence fournie par ladite troisième référence de tension Z3 est comprise entre 5 Volt et 20 Volt. Les positions de la troisième résistance R3 et de la troisième référence de tension Z3 peuvent être inversées, tout en restant en série et dans la mesure où l'anode de la troisième référence de tension Z3 est orientée vers la borne de référence 11. Les figures 3 et 4 représentent l'anode de la troisième référence de tension Z3 connectée à la borne de référence 11 et une première extrémité de la troisième résistance R3 connectée à la cathode de la troisième référence de tension Z3. Il est également possible de connecter la cathode de la troisième référence de tension Z3 à la base du troisième transistor S3 et connecter la première extrémité de la troisième résistance R3 à la borne de référence 11.

Quand la tension entre la borne d'entrée 10 et la borne de sortie 12 est supérieure à la tension de référence fournie par la deuxième référence de tension Z2, un courant circule dans la deuxième résistance R2, la deuxième référence de tension Z2, la base du deuxième transistor S2 et l'émetteur du troisième transistor S3. Quand la tension de sortie Vs1 est supérieure à la tension de référence fournie par la troisième référence de tension Z3, alors le deuxième transistor S2 et le troisième transistor S3 sont conducteurs, le premier transistor S1 est bloqué, il s'agit du cas où l'écart d'amplitude entre la tension d'entrée Ve et la tension de sortie Vs1 est supérieur ou égal au premier seuil Vref1 et la tension de sortie Vs1 est supérieure ou égale au second seuil Vref2. En revanche, quand la tension de sortie Vs1 est inférieure à la tension de référence fournie par la troisième référence de tension Z3, alors le deuxième transistor S2 et le troisième transistor S3 sont bloqués. Dans ce cas, le premier transistor S1 est conducteur, il s'agit du cas où l'écart d'amplitude entre la tension d'entrée Ve et la tension de sortie Vs1 est supérieur ou égal au premier seuil Vref1 et la tension de sortie Vs1 est inférieure ou égale au second seuil Vref2, c'est-à-dire d'une mise sous tension du circuit de régulation alors que la tension de sortie Vs1 est faible.

Quand la tension entre la borne d'entrée 10 et la borne de sortie 12 est inférieure à la tension de référence fournie par la deuxième référence de tension Z2, le deuxième transistor S2 est bloqué, le premier transistor S1 fonctionne en mode régulateur de tension ou « LDO » et fournit une tension de sortie Vs1 régulée d'amplitude sensiblement égale à la tension de référence fournie par la première référence de tension Z1 ainsi que décrit précédemment.

Un condensateur C1, connecté entre la borne de sortie 12 et la borne de référence 11, constitue une réserve d'énergie pour alimenter les circuits connectés entre la borne de sortie 12 et la borne de référence 11 quand le premier transistor S1 est dans un état non conducteur.

L'invention porte également sur un module d'alimentation régulée 3 comportant un circuit de régulation 1 tel que décrit précédemment. La figure 4 représente un schéma préférentiel de réalisation d'un tel module d'alimentation régulée 3 comportant :
- un circuit de régulation 1 tel que décrit précédemment,
- au moins deux bornes de connexion réseau AC1, AC2 pour connecter le module d'alimentation régulée 3 à un réseau de distribution d'énergie électrique fournissant une tension alternative Vac,
- un pont redresseur BR1 comportant des entrées alternatives, une sortie positive et une sortie négative, les entrées alternatives étant connectées aux bornes de connexion réseau AC1, AC2, la sortie positive étant connectée à la borne d'entrée 10 du circuit de régulation 1, la sortie négative étant connectée à la borne de référence 11 du circuit de régulation 1.

De préférence, des composants limiteurs de tension RS1, RS2, TVS1, .., TVSn sont connectés en série entre la borne d'entrée 10 et la borne de référence 11 pour écrêter des surtensions transmises par le réseau de distribution d'énergie électrique. Le nombre de composants limiteurs TVS1, .., TVSn est déterminé en fonction du niveau de surtension à partir duquel la tension alternative Vac doit être écrêtée.

Pour améliorer le comportement du circuit de régulation en présence de perturbations électromagnétiques, une quatrième résistance R4 est connectée en parallèle entre la base et l'émetteur du deuxième transistor S2 et une cinquième résistance R5 est connectée en parallèle entre la base et l'émetteur du troisième transistor S3. La quatrième et la cinquième résistance R4 et R5 ont préférentiellement une valeur comprise entre 10 kOhm et 470 kOhm.

Le module d'alimentation régulée 3 comporte un convertisseur à découpage BC, de préférence un hacheur série de type « Buck », une entrée BC1 dudit convertisseur à découpage BC étant connectée à la borne de sortie 12 du circuit de régulation 1, une entrée de référence BC2 étant connectée à la borne de référence 11 et une sortie BC3 du convertisseur à découpage fournissant une tension d'alimentation régulée Vs2 par rapport à la borne de référence 11. Ladite tension d'alimentation régulée Vs2 est utilisable pour alimenter, par exemple, des circuits de traitement du signal dans un appareil de protection contre les courants de défaut, tels qu'un disjoncteur différentiel. Un tel module d'alimentation régulée 3 peut également être utilisé dans tout équipement nécessitant une alimentation sous une tension Vs2 extrêmement rapide, par exemple dans un délai de quelques millisecondes après la mise sous tension, tel qu'un appareil de protection contre un défaut électrique, un appareil de surveillance médicale ou encore un automate fonctionnant dans le cadre d'un process continu, cette liste étant non limitative.

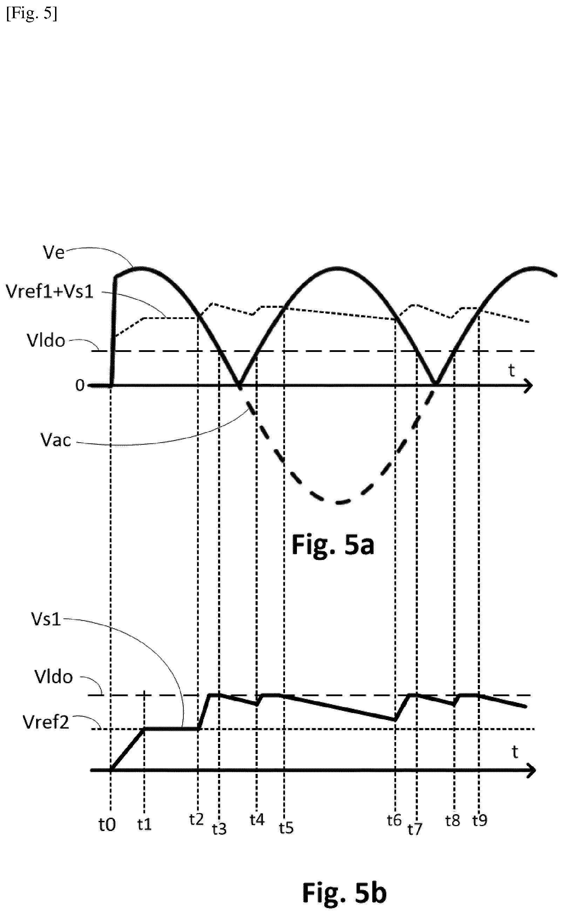

La figure 5a est une représentation temporelle des variations de la tension alternative Vac délivrée par le réseau de distribution d'énergie électrique, de la tension d'entrée Ve en entrée du circuit de régulation 1, la tension d'entrée Ve étant obtenue par le redressement, au moyen du pont redresseur BR1, de la tension alternative Vac. Pour plus de clarté dans la description qui suit, le niveau de seuil Vref1+Vs1 et le niveau de tension régulée Vldo sont également représentés, en fonction du temps t.

La figure 5b est une représentation temporelle de la tension de sortie régulée Vs1 fournie par le circuit de régulation 1. Au temps t0, le circuit de régulation 1 reçoit la tension d'entrée Ve, celle -ci correspondant à la tension alternative Vac redressée double alternance. La tension de sortie Vs1 est nulle. Le premier circuit de comparaison 23 compare la différence de potentiel (Ve-Vs1) par rapport à Vref1 ce qui revient à comparer la tension d'entrée Ve par rapport à la somme (Vref1+Vs1).

D'une part, la tension d'entrée Ve étant supérieure à la somme de la tension de sortie Vs1 et du premier seuil Vref1 et, d'autre part, la tension de sortie Vs1 étant inférieure au second seuil Vref2, alors l'interrupteur 22 est fermé, le régulateur de tension 21 fonctionne et le condensateur C1 commence à se charger. La tension de sortie Vs1 augmente jusqu'à atteindre le second seuil Vref2 au temps t1. Le circuit de commande 25 commande alors l'ouverture de l'interrupteur 22, le condensateur C1 reste chargé sous une tension correspondant au second seuil Vref2. Au temps t2, la tension d'entrée Ve est inférieure à la somme de la tension de sortie Vs1 et du premier seuil Vref1 et donc l'interrupteur 22 est fermé. Le régulateur de tension 21 fonctionne et fournit la tension régulée Vldo permettant un complément de charge du condensateur C1, la tension de sortie Vs1 tend vers la valeur de la tension régulée Vldo. Au temps t3, la tension d'entrée Ve passe en dessous de la valeur de la tension régulée Vldo, le régulateur ne fonctionne plus et le condensateur C1 se décharge en fournissant l'énergie consommée par les circuits connectés au module d'alimentation 3. Au temps t4, la tension d'entrée Ve devient supérieure à la valeur de la tension régulée Vldo , le régulateur de tension 21 se remet à fonctionner et fournit la tension régulée Vldo permettant un complément de charge du condensateur C1, puis la tension de sortie Vs1 se stabilise à la valeur de la tension régulée Vldo. Au temps t5, d'une part la tension d'entrée Ve devient supérieure à la somme de la tension de sortie Vs1 et, d'autre part, la tension de sortie Vs1 est supérieure au second seuil Vref2, alors le circuit de commande 25 commande l'ouverture de l'interrupteur 22 et le condensateur C1 se décharge en fournissant l'énergie consommée par les circuits connectés au module d'alimentation 3 jusqu'au temps t6. A cet instant, la tension d'entrée Ve devient inférieure à la somme de la tension de sortie Vs1 et du premier seuil Vref1 et donc l'interrupteur 22 est fermé, le régulateur de tension 21 fonctionne, complète la charge du condensateur C1 et régule la tension de sortie Vs1 à la valeur de la tension régulée Vldo, de façon identique à la période entre t2 et t3, jusqu'au temps t7. Ensuite, un cycle identique se reproduit.

Le circuit de régulation en tension 1 permet la fourniture d'une tension de sortie Vs1 très rapidement après une mise sous tension, l'intervalle de temps entre le temps t1 et le temps t0 étant typiquement de quelques millisecondes, y compris dans le cas où l'amplitude de la tension d'entrée Ve est très grande par rapport à la tension de sortie Vs1. De plus, le fonctionnement du circuit de régulation en tension 1 apporte une réduction notable des pertes Joule dans le régulateur de tension 21. Enfin, le circuit de régulation, et tout particulièrement tel que représenté et décrit en figure 3, peut être réalisé avec un faible nombre de composants, dans un volume extrêmement réduit, très attractif économiquement.

## Revendications

1. Circuit de régulation en tension (1) comportant au moins une borne d'entrée (10), une borne de référence (11) et une borne de sortie (12), une source de tension (2), connectée entre la borne d'entrée (10) et la borne de référence (11), fournissant une tension d'entrée (Ve), ledit circuit de régulation (1) fournissant une tension de sortie (Vs1) régulée entre la borne de sortie (12) et la borne de référence (11), et comportant :
- un régulateur de tension (21),
- un interrupteur (22), connecté en série avec le régulateur de tension (21) entre la borne d'entrée (10) et la borne de sortie (12), ledit interrupteur (22) et ledit régulateur de tension (21) formant un premier ensemble,
- un premier circuit de comparaison (23) connecté à la borne d'entrée (10) et à la borne de sortie (12), ledit premier circuit de comparaison (23) étant agencé pour comparer l'écart d'amplitude entre la tension d'entrée (Ve) et la tension de sortie (Vs1) par rapport à un premier seuil (Vref1),
- un second circuit de comparaison (24), connecté à la borne de sortie (12) et à la borne de référence (11), ledit second circuit de comparaison (24) étant agencé pour comparer l'amplitude de la tension de sortie (Vs1) par rapport à un second seuil (Vref2), et
- un circuit de commande (25), connecté au premier circuit de comparaison (23), au second circuit de comparaison (24) et à l'interrupteur (22), ledit circuit de commande (25) étant agencé pour commander une fermeture ou une ouverture de l'interrupteur (22),
le circuit de régulation (1) étant **caractérisé en ce que** le circuit de commande (25) est configuré pour commander une ouverture ou une fermeture de l'interrupteur (22) en fonction :
- de la comparaison de l'écart d'amplitude entre la tension d'entrée (Ve) et la tension de sortie (Vs1) par rapport au premier seuil (Vref1), et
- de la comparaison de l'amplitude de la tension de sortie (Vs1) par rapport au second seuil (Vref2),
le circuit de commande (25) est configuré pour commander :
- une ouverture de l'interrupteur (22) quand l'écart d'amplitude entre la tension d'entrée (Ve) et la tension de sortie (Vs1) est supérieur ou égal au premier seuil (Vref1),
- une fermeture de l'interrupteur (22) quand l'écart d'amplitude entre la tension d'entrée (Ve) et la tension de sortie (Vs1) est inférieur au premier seuil (Vref1), et
- une fermeture de l'interrupteur (22) quand l'écart d'amplitude entre la tension d'entrée (Ve) et la tension de sortie (Vs1) est supérieur ou égal au premier seuil (Vref1) et que la tension de sortie (Vs1) est inférieure au second seuil (Vref2).

2. Circuit de régulation (1) selon la revendication 1, **caractérisé en ce que** le premier ensemble constitué par l'interrupteur (22) connecté en série avec le régulateur de tension (21) est formé par :
- un premier transistor (S1) dont le collecteur est connecté à la borne d'entrée (10), et dont l'émetteur est connecté à la borne de sortie (12),
- une première résistance (R1), une première extrémité de ladite première résistance (R1) étant connectée à la base du premier transistor (S1), une deuxième extrémité de la première résistance (R1) étant connectée au collecteur du premier transistor (S1), et
- une première référence de tension (Z1) dont l'anode est connectée à la borne de référence (11) et la cathode est connectée à la base du premier transistor (S1).

3. Circuit de régulation selon la revendication précédente, **caractérisé en ce que** l'amplitude de la tension de sortie (Vs1) est fixée par la tension de référence fournie par la première référence de tension (Z1).

4. Circuit de régulation (1) selon l'une des revendications 2 ou 3, **caractérisé en ce que** le premier circuit de comparaison (23) est formé d'un deuxième transistor (S2) de type bipolaire NPN dont le collecteur est connecté à la base du premier transistor (S1) et dont la base est connectée à une première extrémité d'un deuxième ensemble formé par une deuxième résistance (R2) connectée en série avec une deuxième référence de tension (Z2), une deuxième extrémité du deuxième ensemble étant connectée à la borne d'entrée (10), l'anode de la deuxième référence de tension (Z2) étant orientée vers la base du premier transistor (S1).

5. Circuit de régulation (1) selon la revendication précédente, **caractérisé en ce que** l'amplitude du premier seuil (Vref1) est fixée par la tension de référence fournie par la deuxième référence de tension (Z2).

6. Circuit de régulation (1) selon l'une des revendications 4 ou 5, **caractérisé en ce que** le second circuit de comparaison (24) est formé d'un troisième transistor (S3) de type bipolaire PNP dont l'émetteur est connecté à l'émetteur du deuxième transistor (S2), le collecteur dudit troisième transistor (S3) étant connecté à la borne de sortie (12), la base étant connectée à une première extrémité d'un troisième ensemble formé par une troisième résistance (R3) connectée en série avec une troisième référence de tension (Z3), une deuxième extrémité du troisième ensemble étant connectée à la borne de référence (11), l'anode de ladite troisième référence de tension (Z3) étant orientée vers la borne de référence (11).

7. Circuit de régulation (1) selon la revendication précédente, **caractérisé en ce que** l'amplitude du second seuil (Vref2) est fixée par la tension de référence fournie par la troisième référence de tension (Z3).

8. Circuit de régulation (1) selon l'une des revendications 6 ou 7, **caractérisé en ce qu'**une quatrième résistance (R4) est connectée en parallèle entre la base et l'émetteur du deuxième transistor (S2) et **en ce qu'**une cinquième résistance (R5) est connectée en parallèle entre la base et l'émetteur du troisième transistor (S3).

9. Circuit de régulation (1) selon l'une quelconque des revendications précédentes, **caractérisé en ce qu'**un condensateur (C1) est connecté entre la borne de sortie (12) et la borne de référence (11).

10. Module d'alimentation régulée (3) **caractérisé en ce qu'**il comporte :
- un circuit de régulation (1) selon l'une des revendications précédentes,
- au moins deux bornes de connexion réseau (AC1, AC2) connectées à un réseau de distribution d'énergie électrique fournissant une tension alternative (Vac),
- un pont redresseur (BR1) comportant des entrées alternatives, une sortie positive et une sortie négative, les entrées alternatives étant connectées aux bornes de connexion réseau (AC1, AC2), la sortie positive étant connectée à la borne d'entrée (10) du circuit de régulation (1), la sortie négative étant connectée à la borne de référence (11) du circuit de régulation (1).

11. Module d'alimentation régulée (3) selon la revendication précédente **caractérisé en ce qu'**il comporte un convertisseur à découpage (BC) de type Buck, une entrée (BC1) dudit convertisseur à découpage (BC) étant connectée à la borne de sortie (12) du circuit de régulation (1) et une sortie (BC3) du convertisseur à découpage fournissant une tension d'alimentation régulée (Vs2).

## Patentansprüche

1. Spannungsregelschaltung (1), umfassend mindestens einen Eingangsanschluss (10), einen Referenzanschluss (11) und einen Ausgangsanschluss (12), eine Spannungsquelle (2), die zwischen dem Eingangsanschluss (10) und dem Referenzanschluss (11) angeschlossen ist, die eine Eingangsspannung (Ve) bereitstellt, wobei die Regelschaltung (1) eine geregelte Ausgangsspannung (Vs1) zwischen dem Ausgangsanschluss (12) und dem Referenzanschluss (11) bereitstellt, und umfassend:
- einen Spannungsregler (21),
- einen Schalter (22), der in Reihe mit dem Spannungsregler (21) zwischen dem Eingangsanschluss (10) und dem Ausgangsanschluss (12) angeschlossen ist, wobei der Schalter (22) und der Spannungsregler (21) eine erste Baugruppe bilden,
- eine erste Vergleichsschaltung (23), die mit dem Eingangsanschluss (10) und mit dem Ausgangsanschluss (12) verbunden ist, wobei die erste Vergleichsschaltung (23) dazu eingerichtet ist, die Amplitudendifferenz zwischen der Eingangsspannung (Ve) und der Ausgangsspannung (Vs1) in Bezug auf einen ersten Schwellenwert (Vref1) zu vergleichen,
- eine zweite Vergleichsschaltung (24), die mit dem Ausgangsanschluss (12) und mit dem Referenzanschluss (11) verbunden ist, wobei die zweite Vergleichsschaltung (24) dazu eingerichtet ist, die Amplitude der Ausgangsspannung (Vs1) in Bezug auf einen zweiten Schwellenwert (Vref2) zu vergleichen, und
- eine Steuerschaltung (25), die mit der ersten Vergleichsschaltung (23), mit der zweiten Vergleichsschaltung (24) und mit dem Schalter (22) verbunden ist, wobei die Steuerschaltung (25) dazu eingerichtet ist, ein Schließen oder ein Öffnen des Schalters (22) zu steuern,
wobei die Regelschaltung (1) **dadurch gekennzeichnet ist, dass** die Steuerschaltung (25) konfiguriert ist, um ein Öffnen oder ein Schließen des Schalters (22) in Abhängigkeit von Folgendem zu steuern:
- dem Vergleich der Amplitudendifferenz zwischen der Eingangsspannung (Ve) und der Ausgangsspannung (Vs1) in Bezug auf den ersten Schwellenwert (Vref1), und
- dem Vergleich der Amplitude der Ausgangsspannung (Vs1) in Bezug auf den zweiten Schwellenwert (Vref2).
Die Steuerschaltung (25) ist konfiguriert, um Folgendes zu steuern:
- ein Öffnen des Schalters (22), wenn die Amplitudendifferenz zwischen der Eingangsspannung (Ve) und der Ausgangsspannung (Vs1) größer oder gleich dem ersten Schwellenwert (Vref1) ist,
- ein Schließen des Schalters (22), wenn die Amplitudendifferenz zwischen der Eingangsspannung (Ve) und der Ausgangsspannung (Vs1) kleiner als der erste Schwellenwert (Vref1) ist, und
- ein Schließen des Schalters (22), wenn die Amplitudendifferenz zwischen der Eingangsspannung (Ve) und der Ausgangsspannung (Vs1) größer oder gleich dem ersten Schwellenwert (Vref1) ist und wenn die Ausgangsspannung (Vs1) kleiner als der zweite Schwellenwert (Vref2) ist.

2. Regelschaltung (1) nach Anspruch 1, **dadurch gekennzeichnet, dass** die erste Baugruppe, die durch den Schalter (22) gebildet ist, der in Reihe mit dem Spannungsregler (21) angeschlossen ist, durch Folgendes gebildet ist:
- einen ersten Transistor (S1), dessen Kollektor mit dem Eingangsanschluss (10) verbunden ist, und dessen Emitter mit dem Ausgangsanschluss (12) verbunden ist,
- einen ersten Widerstand (R1), wobei ein erstes Ende des ersten Widerstands (R1) mit der Basis des ersten Transistors (S1) verbunden ist, wobei ein zweites Ende des ersten Widerstands (R1) mit dem Kollektor des ersten Transistors (S1) verbunden ist, und
- eine erste Spannungsreferenz (Z1), deren Anode mit dem Referenzanschluss (11) verbunden ist und deren Kathode mit der Basis des ersten Transistors (S1) verbunden ist.

3. Regelschaltung nach dem vorhergehenden Anspruch, **dadurch gekennzeichnet, dass** die Amplitude der Ausgangsspannung (Vs1) durch die Referenzspannung festgelegt ist, die von der ersten Spannungsreferenz (Z1) bereitgestellt wird.

4. Regelschaltung (1) nach einem der Ansprüche 2 oder 3, **dadurch gekennzeichnet, dass** die erste Vergleichsschaltung (23) aus einem zweiten Transistor (S2) vom bipolaren NPN-Typ gebildet ist, dessen Kollektor mit der Basis des ersten Transistors (S1) verbunden ist und dessen Basis mit einem ersten Ende einer zweiten Baugruppe verbunden ist, die durch einen zweiten Widerstand (R2) gebildet ist, der in Reihe mit einer zweiten Spannungsreferenz (Z2) angeschlossen ist, wobei ein zweites Ende der zweiten Baugruppe mit dem Eingangsanschluss (10) verbunden ist, wobei die Anode der zweiten Spannungsreferenz (Z2) zur Basis des ersten Transistors (S1) hin ausgerichtet ist.

5. Regelschaltung (1) nach dem vorhergehenden Anspruch, **dadurch gekennzeichnet, dass** die Amplitude des ersten Schwellenwerts (Vref1) durch die Referenzspannung festgelegt ist, die von der zweiten Spannungsreferenz (Z2) bereitgestellt wird.

6. Regelschaltung (1) nach einem der Ansprüche 4 oder 5, **dadurch gekennzeichnet, dass** die zweite Vergleichsschaltung (24) aus einem dritten Transistor (S3) vom bipolaren PNP-Typ gebildet ist, dessen Emitter mit dem Emitter des zweiten Transistors (S2) verbunden ist, wobei der Kollektor des dritten Transistors (S3) mit dem Ausgangsanschluss (12) verbunden ist, wobei die Basis mit einem ersten Ende einer dritten Baugruppe verbunden ist, die durch einen dritten Widerstand (R3) gebildet ist, der in Reihe mit einer dritten Spannungsreferenz (Z3) angeschlossen ist, wobei ein zweites Ende der dritten Baugruppe mit dem Referenzanschluss (11) verbunden ist, wobei die Anode der dritten Spannungsreferenz (Z3) zu dem Referenzanschluss (11) hin ausgerichtet ist.

7. Regelschaltung (1) nach dem vorhergehenden Anspruch, **dadurch gekennzeichnet, dass** die Amplitude des zweiten Schwellenwerts (Vref2) durch die Referenzspannung festgelegt ist, die von der dritten Spannungsreferenz (Z3) bereitgestellt wird.

8. Regelschaltung (1) nach einem der Ansprüche 6 oder 7, **dadurch gekennzeichnet, dass** ein vierter Widerstand (R4) parallel zwischen der Basis und dem Emitter des zweiten Transistors (S2) angeschlossen ist und dass ein fünfter Widerstand (R5) parallel zwischen der Basis und dem Emitter des dritten Transistors (S3) angeschlossen ist.

9. Regelschaltung (1) nach einem beliebigen der vorhergehenden Ansprüche, **dadurch gekennzeichnet, dass** ein Kondensator (C1) zwischen dem Ausgangsanschluss (12) und dem Referenzanschluss (11) angeschlossen ist.

10. Geregeltes Stromversorgungsmodul (3), **dadurch gekennzeichnet, dass** es Folgendes umfasst:
- eine Regelschaltung (1) nach einem der vorhergehenden Ansprüche,
- mindestens zwei Netzanschlussklemmen (AC1, AC2), die mit einem elektrischen Energieverteilungsnetz verbunden sind, das eine Wechselspannung (Vac) bereitstellt,
- eine Gleichrichterbrücke (BR1), umfassend Wechseleingänge, einen positiven Ausgang und einen negativen Ausgang, wobei die Wechseleingänge mit den Netzanschlussklemmen (AC1, AC2) verbunden sind, wobei der positive Ausgang mit dem Eingangsanschluss (10) der Regelschaltung (1) verbunden ist, wobei der negative Ausgang mit dem Referenzanschluss (11) der Regelschaltung (1) verbunden ist.

11. Geregeltes Stromversorgungsmodul (3) nach dem vorhergehenden Anspruch, **dadurch gekennzeichnet, dass** es einen Schaltwandler (BC) vom Buck-Typ umfasst, wobei ein Eingang (BC1) des Schaltwandlers (BC) mit dem Ausgangsanschluss (12) der Regelschaltung (1) verbunden ist und wobei ein Ausgang (BC3) des Schaltwandlers eine geregelte Versorgungsspannung (Vs2) bereitstellt.

## Claims

1. Voltage regulation circuit (1) comprising at least one input terminal (10), a reference terminal (11) and an output terminal (12), a voltage source (2), connected between the input terminal (10) and the reference terminal (11), supplying an input voltage (Ve), said regulation circuit (1) supplying a regulated output voltage (Vs1) between the output terminal (12) and the reference terminal (11), and comprising:
- a voltage regulator (21),
- a switch (22), connected in series with the voltage regulator (21) between the input terminal (10) and the output terminal (12), said switch (22) and said voltage regulator (21) forming a first assembly,
- a first comparison circuit (23) connected to the input terminal (10) and to the output terminal (12), said first comparison circuit (23) being arranged to compare the magnitude difference between the input voltage (Ve) and the output voltage (Vs1) with respect to a first threshold (Vref1),
- a second comparison circuit (24), connected to the output terminal (12) and to the reference terminal (11), said second comparison circuit (24) being arranged to compare the magnitude of the output voltage (Vs1) with respect to a second threshold (Vref2), and
- a control circuit (25), connected to the first comparison circuit (23), to the second comparison circuit (24) and to the switch (22), said control circuit (25) being arranged to control a closing or an opening of the switch (22),
the regulation circuit (1) being **characterized in that** the control circuit (25) is configured to control an opening or a closing of the switch (22) as a function:
- of the comparison of the magnitude difference between the input voltage (Ve) and the output voltage (Vs1) with respect to the first threshold (Vref1), and
- of the comparison of the magnitude of the output voltage (Vs1) with respect to the second threshold (Vref2),
the control circuit (25) is configured to control:
- an opening of the switch (22) when the magnitude difference between the input voltage (Ve) and the output voltage (Vs1) is greater than or equal to the first threshold (Vref1),
- a closing of the switch (22) when the magnitude difference between the input voltage (Ve) and the output voltage (Vs1) is less than the first threshold (Vref1), and
- a closing of the switch (22) when the magnitude difference between the input voltage (Ve) and the output voltage (Vs1) is greater than or equal to the first threshold (Vref1) and the output voltage (Vs1) is less than the second threshold (Vref2).

2. Regulation circuit (1) according to claim 1, **characterized in that** the first assembly constituted by the switch (22) connected in series with the voltage regulator (21) is formed by:
- a first transistor (S1) of which the collector is connected to the input terminal (10), and of which the emitter is connected to the output terminal (12),
- a first resistor (R1), a first end of said first resistor (R1) being connected to the base of the first transistor (S1), a second end of the first resistor (R1) being connected to the collector of the first transistor (S1), and
- a first voltage reference (Z1) of which the anode is connected to the reference terminal (11) and the cathode is connected to the base of the first transistor (S1).

3. Regulation circuit according to the preceding claim, **characterized in that** the magnitude of the output voltage (Vs1) is set by the reference voltage supplied by the first voltage reference (Z1).

4. Regulation circuit (1) according to one of claims 2 or 3, **characterized in that** the first comparison circuit (23) is formed of a second transistor (S2) of NPN bipolar type of which the collector is connected to the base of the first transistor (S1) and of which the base is connected to a first end of a second assembly formed by a second resistor (R2) connected in series with a second voltage reference (Z2), a second end of the second assembly being connected to the input terminal (10), the anode of the second voltage reference (Z2) being oriented toward the base of the first transistor (S1).

5. Regulation circuit (1) according to the preceding claim, **characterized in that** the magnitude of the first threshold (Vref1) is set by the reference voltage supplied by the second voltage reference (Z2).

6. Regulation circuit (1) according to one of claims 4 or 5, **characterized in that** the second comparison circuit (24) is formed of a third transistor (S3) of PNP bipolar type of which the emitter is connected to the emitter of the second transistor (S2), the collector of said third transistor (S3) being connected to the output terminal (12), the base being connected to a first end of a third assembly formed by a third resistor (R3) connected in series with a third voltage reference (Z3), a second end of the third assembly being connected to the reference terminal (11), the anode of said third voltage reference (Z3) being oriented toward the reference terminal (11).

7. Regulation circuit (1) according to the preceding claim, **characterized in that** the magnitude of the second threshold (Vref2) is set by the reference voltage supplied by the third voltage reference (Z3).

8. Regulation circuit (1) according to one of claims 6 or 7, **characterized in that** a fourth resistor (R4) is connected in parallel between the base and the emitter of the second transistor (S2) and **in that** a fifth resistor (R5) is connected in parallel between the base and the emitter of the third transistor (S3).

9. Regulation circuit (1) according to any one of the preceding claims, **characterized in that** a capacitor (C1) is connected between the output terminal (12) and the reference terminal (11).

10. Regulated power supply module (3) **characterized in that** it comprises:
- a regulation circuit (1) according to one of the preceding claims,
- at least two network connection terminals (AC1, AC2) connected to an electrical energy distribution network supplying an alternating voltage (Vac),
- a rectifier bridge (BR1) comprising alternating inputs, a positive output and a negative output, the alternating inputs being connected to the network connection terminals (AC1, AC2), the positive output being connected to the input terminal (10) of the regulation circuit (1), the negative output being connected to the reference terminal (11) of the regulation circuit (1).

11. Regulated power supply module (3) according to the preceding claim **characterized in that** it comprises a Buck-type switching converter (BC), an input (BC1) of said switching converter (BC) being connected to the output terminal (12) of the regulation circuit (1) and an output (BC3) of the switching converter supplying a regulated supply voltage (Vs2).
